# EUROPÄISCHE PATENTSCHRIFT

(11) **EP 0 760 971 B1**
(45) Veröffentlichungstag und Bekanntmachung des Hinweises auf die Patenterteilung: **04.08.1999**
(21) Anmeldenummer: 95918519.0
(22) Anmeldetag: 11.05.1995
(51) Int. Cl.: G03F 7/038

(54) **TROCKENENTWICKELBARER POSITIVRESIST**
DRY-DEVELOPABLE POSITIVE RESIST
RESIST POSITIF DEVELOPPABLE A SEC

(30) Priorität: 25.05.1994 DE 4418205
(43) Veröffentlichungstag der Anmeldung: 12.03.1997
(73) Patentinhaber: SIEMENS AKTIENGESELLSCHAFT, 80333 München (DE)
(72) Erfinder: SEZI, Recai, D-91341 Röttenbach (DE); LEUSCHNER, Rainer, D-91056 Erlangen (DE); BORNDÖRFER, Horst, D-82377 Penzberg (DE); RISSEL, Eva-Maria, D-91301 Forchheim (DE); SEBALD, Michael, D-91085 Weisendorf (DE); AHNE, Hellmut, D-91341 Röttenbach (DE); BIRKLE, Siegfried, D-91315 Höchstadt (DE); KÜHN, Eberhard, D-91334 Hemhofen (DE)
(86) Internationale Anmeldenummer: DE9500626
(87) Internationale Veröffentlichungsnummer: WO9532455

(56) Entgegenhaltungen:
- EP-A- 0 307 752
- EP-A- 0 453 610
- EP-A- 0 492 256
- DATABASE WPI Section Ch, Week 9441 Derwent Publications Ltd., London, GB; Class A21, AN 94-326985 & JP,A,06 250 390 ( NIPPON OILS & FATS CO LTD) , 9.September 1994

## Beschreibung

Die Erfindung betrifft einen trockenentwickelbaren, positiv arbeitenden TSI-Resist.

Bei der photolithographischen Strukturerzeugung zeigen trockenentwickelbare TSI-Einlagenresists (TSI = Top Surface Imaging) eine Reihe von Vorteilen, wie Unterdrückung von Reflexionen und Verringerung der Topographieeffekte. Eine detaillierte Beschreibung derartiger Systeme findet sich in "Introduction to Microlithography", ACS Symposium Series 219 (1983), Seiten 287 bis 350.

TSI-Resists sind sowohl in Form positiv arbeitender als auch in Form negativ arbeitender, trockenentwickelbarer Einlagensysteme bekannt. Im Gegensatz zu negativ arbeitenden Systemen sind positiv arbeitende TSI-Systeme - wegen einer geringeren Defektdichte - viel besser für Anwendungen in den Kontaktlochebenen, die sehr kritisch sind, geeignet.

Trockenentwickelbare Einlagensysteme arbeiten nach folgendem Prinzip:
- Aufbringen des Resists auf einen Siliciumwafer und Trocknen;
- Belichten und gegebenenfalls Aufheizen, um ein "latentes" Bild zu erzeugen;
- Behandeln mit einem Metallisierungsagens, beispielsweise eine Organometallverbindung, wodurch der Resist - in den belichteten Bereichen (Negativresist) oder in den unbelichteten Bereichen (Positivresist) - resistent wird gegen Trockenentwicklung, insbesondere im Sauerstoffplasma;
- Trockenentwickeln.

Diese Anzahl von Prozeßschritten soll bei der Produktion möglichst nicht überschritten werden.

Ein produktionstaugliches hochauflösendes TSI-System soll darüber hinaus folgenden Anforderungen genügen:
1. Einfache und linienkompatible Prozessierung
   Mehr Prozeßschritte als die vorstehend genannten bedeuten einen höheren Kostenaufwand, wobei die Mehrkosten durch Investitionen für zusätzliche Geräte und/oder Reagenzien sowie durch die zusätzlichen Prozeßschritte verursacht sein können.
2. Hohe Empfindlichkeit
   Um so geringer die Empfindlichkeit ist, um so geringer ist der Durchsatz bei den teuren Belichtungsgeraten (Stepper) und um so höher sind die Kosten. Dabei ist insbesondere eine hohe Empfindlichkeit im DUV-Bereich wichtig (DUV = Deep UV).
3. Hohe Resistenz gegen Plasmaentwicklung
   Eine hohe Resistenz der mit dem Metallisierungsagens behandelten Bereiche ist für einen hohen Prozeßspielraum beim Trockenentwickeln wichtig.

Um das Problem einer geringen DUV-Empfindlichkeit von Photoresists zu lösen, wurden Resistsysteme entwickelt, deren Basispolymer tert.-Butylester- oder tert.-Butoxycarbonyloxy-Gruppen aufweist (siehe dazu EP-OS 0 102 450 und 0 161 476 bzw. die entsprechenden US-Patentschriften 4 491 628 und 4 552 833). Beim Belichten in Gegenwart eines starken Säurebildners, beispielsweise eines Crivellosalzes, werden dabei Carboxyl- bzw. phenolische OH-Gruppen erzeugt, wobei ein einziges Proton - nach dem Prinzip der sogenannten chemischen Verstärkung ("chemical amplification") - mehrere Gruppen abspaltet (siehe dazu beispielsweise "J. Electrochem. Soc.", Vol. 136 (1989), Seiten 1453 bis 1456).

Auch durch Katalyse mit starken Säuren können kationische Polymerisationen bzw. Vernetzungen durchgeführt werden, die sich zur Anwendung in Resistsystemen mit hoher DUV-Empfindlichkeit eignen. Ein im DUV-Bereich sehr empfindlicher negativer TSI-Resist, der nach dem Prinzip der säurekatalysierten Polymerisation arbeitet, ist beispielsweise in der EP-OS 0 192 078 bzw. der entsprechenden US-PS 4 551 418 beschrieben. Über die Anwendung der säurekatalysierten Vernetzung in Photoresistsystemen, beispielsweise durch elektrophile Substitution an aktivierten Aromaten in Gegenwart von Crivellosalzen, wurde bei der 8th International Conference on Photopolymers, Ellenville, N.Y. (1988), berichtet (siehe Tagungsbericht: Seiten 63 bis 72).

Es sind auch bereits mehrere positiv arbeitende TSI-Systeme bekannt, die aber den vorstehend genannten Anforderungen jeweils nicht vollständig genügen:
- EP-OS 0 136 130
   Mit dem beschriebenen Verfahren können - mit UV-Licht oder Elektronenstrahlen - positive und negative Strukturen erzeugt werden. Von Nachteil ist der Bedarf an speziellen Apparaturen (für Vakuum) sowie das Erfordernis einer Metallisierung mit korrosiven bzw. toxischen Gasen, wie B₂H₆, SiCl₄ und TiCl₄, was für die Fertigung wenig geeignet ist.
- EP-OS 0 204 253 (bzw. US-PS 4 613 398)
   Es werden positiv und negativ arbeitende Systeme beschrieben, wobei die Permeabilität des Resists gegenüber dem Metallisierungsagens durch die Belichtung verändert wird. Nachteil dieses Systems im Positiv-Mode sind eine geringe DUV-Empfindlichkeit (50 bis 300 mJ/cm²) und das Erfordernis einer Silylierung mit Hexamethylcyclotrisilazan in o-Xylol bei 65°C, wozu eine spezielle Apparatur erforderlich und somit eine geringe Linienkompatibilität gegeben ist.
- EP-OS 0 229 917 (bzw. US-PS 4 657 845)
   Es wird ein Verfahren beschrieben, das auf dem Prinzip der chemischen Verstarkung beruht und eine hohe DUV-Empfindlichkeit aufweist (ca. 6 mJ/cm²). Hierbei werden aber zwei zusätzliche Prozeßschritte benötigt, nämlich eine metallfreie Behandlung mit Methylisocyanat, und zwar im Vakuumofen, sowie eine Flutbelichtung.
- EP-OS 0 248 779
   Das beschriebene Verfahren kommt zwar mit wenigen Prozeßschritten aus, es wird jedoch eine spezielle Apparatur für eine Gasphasensilylierung bei erhöhter Temperatur benötigt.
- EP-OS 0 281 182 und EP-OS 0 352 739 (bzw. US-PS 4 921 778) Die beschriebenen Systeme weisen zwar eine gute DUV-Empfindlichkeit auf, sie haben aber den Nachteil, daß spezielle Apparaturen für eine Silylierung aus der Gasphase bei erhöhter Temperatur erforderlich sind. Außerdem weisen die silylierten Bereiche - aufgrund des Einbaus von monomeren Siliciumfragmenten, wie Si(CH₃)₃-Gruppen - nur eine mäßige Ätzresistenz auf (siehe dazu auch: "Microelectronic Engineering", Vol. 3 (1985), Seiten 279 bis 291).
- "Mat. Res. Soc. Symp. Proc.", Vol. 45 (1985), Seiten 197 bis 202, sowie "IBM Techn. Discl. Bull.", Vol. 27, No. 4A (1984), Seite 2197
   Das beschriebene Verfahren basiert auf der Decarboxylierung von Homo- oder Copolymeren von (Meth)acrylsäure, und gegebenenfalls dessen Anhydrid, durch energiereiche Strahlung und Silylierung der unbelichteten Bereiche aus der Gasphase. Die Nachteile bestehen in der Gasphasensilylierung (Erfordernis von speziellem Equipment), der relativ geringen Ätzresistenz im Sauerstoffplasma (aufgrund einer Silylierung mit Hexamethyldisilazan) und der geringeren DUV-Empfindlichkeit einer Decarboxylierungsreaktion der genannten Art.
- "J. Vac. Sci. Technol. B", Vol. 10 (1992), Seiten 2610 bis 2614
   Beschrieben wird die Silylierung von Resists auf Novolak-basis aus flüssiger Phase mit Hexamethylcyclotrisilazan. Dieses Silylierungsreagenz erfordert aber - wegen seiner Feuchteempfindlichkeit - geschlossene Spezialapparaturen. Außerdem weisen die eingesetzten Novolakresists OH-Gruppen auf, die unter Bildung von O-Si-Bindungen silyliert werden. Die Ätzresistenz derartiger Systeme ist aber vergleichsweise gering.

Es wurde ferner bereits ein Strukturierungsverfahren mit Trockenentwicklung vorgeschlagen, das positive Bilder liefert, wobei - unter Verwendung üblicher Apparaturen - Subhalbmikron-Strukturen erzeugt werden können (siehe EP-OS 0 451 311 bzw. die entsprechende US-PS 5 229 258). Dieses Verfahren beinhaltet aber zwei zusätzliche Prozeßschritte, nämlich eine Behandlung der belichteten Photoresistschicht mit einer polyfunktionellen organischen Verbindung, insbesondere einem Polyamin, und eine Flutbelichtung.

Aus der EP-OS 0 492 256 ist ein Verfahren zur photolithographischen Strukturerzeugung im Submikron-Bereich bzw. ein dafür geeignetes trockenentwickelbares TSI-Resistsystem bekannt. Dazu wird auf ein Substrat eine Photoresistschicht aus einem Carbonsäureanhydrid- und Carbonsäure-tert.-butylestergruppen enthaltenden Polymer, einem bei Belichtung eine Saure freisetzenden Photoinitiator und einem geeigneten Lösungsmittel aufgebracht. Die Photoresistschicht wird dann getrocknet und bildmäßig belichtet und die belichtete Schicht einer Temperaturbehandlung ausgesetzt. Die Temperaturbehandlung wird dabei so geführt, daß der Photoresist in den belichteten Bereichen hydrophil wird. Anschließend wird die derart behandelte Photoresistschicht einer Flüssigsilylierung unterworfen und die silylierte Schicht in einem anisotropen Sauerstoffplasma trocken entwickelt. Das bekannte TSI-Resistsystem weist zwar eine hohe Ätzresistenz und eine hohe Empfindlichkeit auf, es können aber Benetzungsprobleme bei der Behandlung mit der Silylierungslösung auftreten, und zwar bei der Silylierung mit unpolaren, aprotischen Medien, d.h. beim Positiv-Mode.

Aufgabe der Erfindung ist es, einen einfach prozessierbaren, insbesondere für DUV-Strahlung empfindlichen, trocken entwickelbaren und positiv arbeitenden TSI-Resist für den Subhalbmikron-Bereich bereitzustellen, der eine hohe Ätzresistenz der metallisierten Bereiche gegen Trockenentwicklung aufweist. Insbesondere soll der TSI-Resist erlauben, den Metallisierungsprozeß bei Raumtemperatur und bei Raumfeuchte sowie bei Normaldruck durchzuführen, und zwar ohne die Verwendung von Spezialapparaturen.

Dies wird erfindungsgemäß durch einen Resist erreicht, der folgende Komponenten enthält:
- ein geeignetes Lösungsmittel
- einen starken Saurebildner als photoaktive Komponente und
- ein Basispolymer in Form eines Co- oder Terpolymers mit Maleinsäureanhydrid als einen Grundbaustein und Glycidylmethacrylat und/oder einem Styrolderivat folgender Struktur als weiteren Grundbaustein: 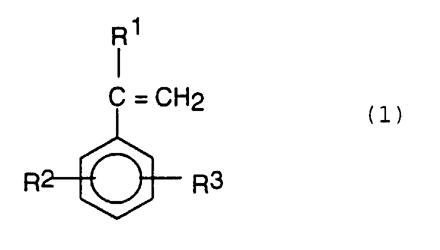 mit
   R¹ = H oder CH₃,
   R² = H oder R³,
   R³ = (CH₂)ₘ-OX,
      wobei X folgende Bedeutung hat:
      (CH₂)ₐ-CH₃, CO-(CH₂)_{c}-CH₃ oder
      CO-(CH₂)_{d}-O-(CH₂)ₑ-CH₃,
      und m, a, c, d und e - unabhängig voneinander - jeweils eine ganze Zahl von 0 bis 5 bedeuten,
      sowie
- gegebenenfalls, bei m = 0 jedoch zwingend, ein Additiv folgender Struktur: 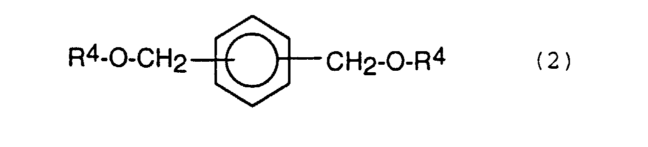 mit R⁴ = CO-(CH₂)ₙ-CH₃ oder CO-C₆H₅,
   wobei n eine ganze Zahl von 0 bis 5 bedeutet.

Beim Positivresist nach der Erfindung ist es wesentlich, daß das Basispolymer wenigstens aus zwei verschiedenen Grundbausteinen aufgebaut ist bzw. daß wenigstens zwei verschiedene funktionelle Gruppen vorhanden sind. Diese funktionellen Gruppen sind zum einen Carbonsaureanhydridgruppen und zum anderen Epoxidgruppen oder aromatische Gruppen der vorstehend beschriebenen Art. Die Anhydridgruppen dienen dabei zur Bildung einer chemischen Bindung beim Silylieren, die Epoxidgruppen bzw. die aromatischen Gruppen für eine säurekatalysierte Vernetzung im DUV-Bereich.

Als Grundbausteine für das Basispolymer dienen deshalb Maleinsäureanhydrid einerseits und entweder Glycidylmethacrylat oder ein Styrolderivat der Struktur (1) andererseits. Wenn das Styrolderivat keine Gruppierung (CH₂)ₘ-OX mit m ≥ 1 besitzt, dann enthält die Resistzusammensetzung zusätzlich ein Additiv mit der Struktur (2). Dieses Additiv, das vorzugsweise p-Bis(acetoxymethyl)-benzol ist, kann aber auch dann vorhanden sein, wenn das Styrolderivat eine Gruppierung der genannten Art aufweist.

Das Basispolymer kann ein Copolymer oder ein Terpolymer sein. Im ersten Fall liegt ein Copolymer aus Maleinsäureanhydrid und Glycidylmethacrylat oder aus Maleinsäureanhydrid und einem Styrolderivat der genannten Art vor. Im zweiten Fall kommt ein dritter Grundbaustein hinzu, der beispielsweise Maleinsäure oder Styrol sein kann. Das Terpolymer kann aber auch aus Maleinsäureanhydrid, Glycidylmethacrylat und einem Styrolderivat der genannten Art aufgebaut sein.

Die photoaktive Komponente ist beim TSI-Resist nach der Erfindung ein starker Saurebildner, d.h. eine Verbindung, die bei Belichtung eine starke Saure bildet. Dazu dienen insbesondere sogenannte Crivellosalze. Dies sind Oniumverbindungen, wie Diphenyljodonium- und Triphenylsulfonium-triflat ("Triflat" ist der Trifluormethansulfonylrest). Es können aber allgemein photoaktive Sulfonsäurebildner verwendet werden. Die photoaktive Komponente wird im allgemeinen in einer Menge von 0,5 bis 5 Masse-% eingesetzt, bezogen auf die Resistzusammensetzung.

Als Lösungsmittel werden beim erfindungsgemaßen Photoresist an sich bekannte Lösungsmittel eingesetzt. Vorzugsweise ist das Resistlösungsmittel Methoxypropylacetat oder Diethylenglykoldimethylether; daneben kann beispielsweise auch Cyclohexanon zum Einsatz gelangen. Wichtig für die Auswahl des Lösungsmittels ist allein das Erfordernis, daß sowohl das Basispolymer als auch die photoaktive Komponente sowie gegebenenfalls das Additiv gelöst werden muß.

Bei der Photostrukturierung ist beim TSI-Resist nach der Erfindung nur die minimale Anzahl an Prozeßschritten erforderlich. Nach dem Aufbringen des Resists auf das Substrat und der Trocknung wird durch eine Maske belichtet und dann getempert. Dadurch erfolgt eine säurekatalysierte Vernetzung der belichteten Bereiche, so daß bei der nachfolgenden Silylierung in flüssiger Phase ein Eindringen der Silylierungslösung in diese Bereiche verhindert wird und die unbelichteten Bereiche selektiv silyliert werden. Als Silylierungsreagens dienen oligomere Bisaminosiloxane. Mit derartigen Verbindungen wird eine hohe Plasmaatzresistenz beim Trockenentwickeln erreicht. Die Silylierung selbst wird in üblichen Sprüh- oder Puddle-Entwicklungsapparaturen bei Raumtemperatur und Raumfeuchte sowie bei Normaldruck durchgeführt. Nach der Silylierung erfolgt eine Trockenentwicklung im anisotropen Sauerstoffplasma. Dabei zeigt sich, daß die Ätzresistenz der silylierten Resistbereiche gegen das Sauerstoffplasma sehr hoch ist. Nach der Trockenentwicklung werden Subhalbmikron-Strukturen mit steilen Flanken erhalten.

Anhand von Ausführungsbeispielen soll die Erfindung noch näher erläutert werden. Dabei finden folgende Ausgangsmaterialien bzw. Reagenzien Verwendung (MT = Masseteile):
- Basispolymer (1):
   Copolymer aus Maleinsäureanhydrid und 4-(Acetoxymethyl)-styrol, hergestellt durch radikalische Polymerisation der Monomere mit Azoisobuttersäurenitril als Initiator.
- Basispolymer (2):
   Terpolymer aus Maleinsäureanhydrid, 4-(Acetoxymethyl)-styrol und Maleinsäure, hergestellt durch radikalische Polymerisation der Monomere mit Azoisobuttersäurenitril als Initiator.
- Basispolymer (3):
   Copolymer aus Maleinsäureanhydrid und Glycidylmethacrylat, hergestellt durch radikalische Polymerisation der Monomere mit Azoisobuttersäurenitril als Initiator.
- Basispolymer (4):
   Copolymer aus Maleinsäureanhydrid und p-Methoxystyrol, hergestellt durch radikalische Polymerisation der Monomere mit Azoisobuttersäurenitril als Initiator.
- Photoaktive Komponente (1):
   Triphenylsulfonium-trifluormethansulfonat
- Photoaktive Komponente (2):
   Diphenyljodonium-trifluormethansulfonat
- Additiv (1):
   p-Bis(acetoxymethyl)-benzol
- Silylierungslösung (1):
   Wäßrig-organische Lösung, bestehend aus 8 MT Diaminosiloxan (Tegomer A-Si 2120 der Fa. Goldschmidt), 61,3 MT Isopropanol, 18,4 MT Diethylenglykoldimethylether und 12,3 MT Wasser
- Silylierungslösung (2):
   Wäßrig-organische Lösung, bestehend aus 8 MT Diaminosiloxan, 51 MT Isopropanol, 26 MT Ethanol und 15 MT Wasser.
- Silylierungslösung (3):
   Organische Lösung, bestehend aus 5 MT Diaminosiloxan, 76 MT Isopropanol und 19 MT Diethylenglykoldimethylether.
- Silylierungslösung (4):
   Wäßrig-organische Lösung, bestehend aus 8 MT Diaminosiloxan, 69 MT Isopropanol, 9,2 MT Diethylenglykoldimethylether und 13,8 MT Wasser.

### Beispiel 1

Auf einen Siliciumwafer wird ein Resist, bestehend aus 23,25 MT Basispolymer (1), 1,75 MT photoaktive Komponente (1) und 75 MT Methoxypropylacetat, aufgeschleudert und 60 s bei 100°C auf einer Heizplatte getrocknet; die Schichtdicke des Resists beträgt 1,2 µm. Der Resist wird dann durch eine Maske mit 6,8 mJ/cm² kontaktbelichtet (Gerät MJB 3, Fa. Karl Süss; Belichtungswellenlänge λ = 250 nm) und 90 s bei 140°C getempert. Nach dem Abkühlen wird der Resist in einer Puddle-Entwicklungsapparatur (Typ CEM 2000, Fa. Convac), bei Raumtemperatur und Raumfeuchte sowie Normaldruck, 75 s mit der Silylierungslösung (1) behandelt und dann 30 s mit Isopropanol gespült und getrocknet. Nach dem Trocknen wird der Wafer in eine Plasmaatzanlage (Typ MIE 720, Fa. Material Research Corporation) gebracht und der Resist im Sauerstoffplasma trocken entwickelt (O₂/RIE: 1,8 mTorr Gasdruck, 30 sccm Gasfluß, 50 V Biasspannung, 1,2 kW Leistung, mit Magnet). Es werden positive Strukturen bis 0,4 µm mit einem Steg/Graben-Verhältnis von 1:1 erhalten.

### Beispiel 2

Auf einen Siliciumwafer wird ein Resist, bestehend aus 21,4 MT Basispolymer (2), 1,6 MT photoaktive Komponente (1) und 77 MT Methoxypropylacetat, aufgeschleudert und 60 s bei 100°C auf einer Heizplatte getrocknet; die Schichtdicke des Resists beträgt 1,2 µm. Der Resist wird dann durch eine Maske mit 7 mJ/cm² kontaktbelichtet (Gerät MJB 3, Fa. Karl Süss; λ = 250 nm) und 90 s bei 140°C getempert. Nach dem Abkühlen wird der Resist in einer Puddle-Entwicklungsapparatur (Typ CEM 2000, Fa. Convac), bei Raumtemperatur und Raumfeuchte sowie Normaldruck, 90 s mit der Silylierungslösung (2) behandelt und dann 30 s mit Isopropanol gespült und getrocknet. Nach dem Trocknen wird der Resist in einer Plasmaatzanlage (Typ MIE 720, Fa. Material Research Corporation) im Sauerstoffplasma - entsprechend Beispiel 1 - trocken entwickelt. Es werden positive Strukturen bis 0,4 µm mit einem Steg/Graben-Verhaltnis von 1:1 erhalten.

### Beispiel 3

Auf einen Siliciumwafer (als Substrat) wird ein käuflicher Positivresist auf Novolak-Basis aufgeschleudert und 1 min auf einer Heizplatte bei 90°C getrocknet. Nach dem Ausheizen in einem Umluftofen (240 °C, 35 min) beträgt die Dicke des als Planarisierungsschicht dienenden Resists 1,3 µm.

Auf die Planarisierungsschicht wird ein Resist, bestehend aus 13,95 MT Basispolymer (3), 1,05 MT photoaktive Komponente (2) und 85 MT Diethylenglykoldimethylether, aufgeschleudert. Nach Trocknung bei 90°C/60 s auf einer Heizplatte beträgt die Schichtdicke dieses Topresists 0,35 µm. Der Resist wird dann durch eine Maske mit 5,5 mJ/cm² kontaktbelichtet (Gerät MJB 3, Fa. Karl Süss; λ = 250 nm) und 60 s bei 110°C getempert. Nach dem Abkühlen wird der Resist in einer Puddle-Entwicklungsapparatur (Typ CEM 2000, Fa. Convec), bei Raumtemperatur und Raumfeuchte sowie Normaldruck, 60 s mit der Silylierungslösung (3) behandelt und dann 30 s mit Isopropanol gespült und getrocknet. Nach dem Trocknen wird der Wafer in eine Plasmaatzanlage (Typ MIE 720, Fa. Material Research Corporation) gebracht und der Resist im Sauerstoffplasma trocken entwickelt (O₂/RIE: 1,8 mTorr Gasdruck, 30 sccm Gasfluß, 40 V Biasspannung, 0,9 kW Leistung, mit Magnet). Es werden positive Strukturen bis 0,4 µm mit senkrechten Flanken und einem Steg/Graben-Verhältnis von 1:1 erhalten.

### Beispiel 4

Auf einen Siliciumwafer wird ein Resist, bestehend aus 13,6 MT Basispolymer (4), 5,0 MT Additiv (1), 1,4 MT photoaktive Komponente (1) und 80 MT Methoxypropylacetat, aufgeschleudert und 60 s bei 90°C auf einer Heizplatte getrocknet; die Schichtdicke des Resists beträgt 1,3 µm. Der Resist wird dann durch eine Maske mit 7,5 mJ/cm² kontaktbelichtet (Gerät MJB 3, Fa. Karl Süss; λ = 250 nm) und 60 s bei 110°C getempert. Nach dem Abkühlen wird der Resist in einer Puddle-Entwicklungsapparatur (Typ CEM 2000, Fa. Convac), bei Raumtemperatur und Raumfeuchte sowie Normaldruck, 45 s mit der Silylierungslösung (4) behandelt und dann 30 s mit Isopropanol gespült und getrocknet. Nach dem Trocknen wird der Resist in einer Plasmaätzanlage (Typ MIE 720, Fa. Material Research Corporation) im Sauerstoffplasma - entsprechend Beispiel 1 - trocken entwickelt. Es werden positive Strukturen bis 0,4 µm mit senkrechten Flanken und einem Steg/Graben-Verhältnis von 1:1 erhalten.

### Beispiel 5

Ein Resist entsprechend Beispiel 1 wird in der dort beschriebenen Weise auf einen Siliciumwafer aufgebracht und getrocknet. Anschließend wird - in entsprechender Weise - 75 s in einer Puddle-Entwicklungsapparatur mit der Silylierungslösung (1) behandelt, dann wird 30 s mit Isopropanol gespült und getrocknet. Nach dem Trocknen wird der Wafer in eine Plasmaatzanlage (Typ MIE 720, Fa. Material Research Corporation) gebracht und der Resist 200 s im Sauerstoffplasma trocken geätzt (O₂/RIE: 1,8 mTorr Gasdruck, 30 sccm Gasfluß, 40 V Biasspannung, 0,9 kW Leistung, mit Magnet). Aus der Schichtdickenmessung vor und nach der Ätzung errechnet sich eine Abtragsrate der silylierten Schicht von 0,83 nm/s.

### Beispiel 6

Ein Resist entsprechend Beispiel 3 wird in der dort beschriebenen Weise auf einen Siliciumwafer aufgebracht und getrocknet. Anschließend wird - in entsprechender Weise - 60 s in einer Puddle-Entwicklungsapparatur mit der Silylierungslösung (3) behandelt, dann wird 30 s mit Isopropanol gespült und getrocknet. Nach dem Trocknen wird der Wafer in eine Plasmaatzanlage (Typ MIE 720, Fa. Material Research Corporation) gebracht und der Resist 200 s im Sauerstoffplasma trocken geatzt (O₂/RIE: 1,8 mTorr Gasdruck, 30 sccm Gasfluß, 40 V Biasspannung, 0,9 kW Leistung, mit Magnet). Aus der Schichtdickenmessung vor und nach der Ätzung errechnet sich eine Abtragsrate der silylierten Schicht von 0,78 nm/s.

## Patentansprüche

1. Trockenentwickelbarer, positiv arbeitender TSI-Resist, **dadurch gekennzeichnet,** daß er folgende Komponenten enthält:
- ein geeignetes Lösungsmittel
- einen starken Saurebildner als photoaktive Komponente und
- ein Basispolymer in Form eines Co- oder Terpolymers mit Maleinsäureanhydrid als einen Grundbaustein und Glycidylmethacrylat und/oder einem Styrolderivat folgender Struktur als weiteren Grundbaustein oder in Form eines Terpolymers aus Maleinsäureanhydrid, Maleinsäure und einem Styrolderivat folgender Struktur: 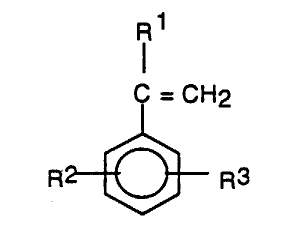 mit
R¹ = H oder CH₃,
R² = H oder R³,
R³ = (CH₂)ₘ-OX,
wobei X folgende Bedeutung hat:
(CH₂)ₐ-CH₃, CO-(CH₂)_{c}-CH₃ oder
CO-(CH₂)_{d}-O-(CH₂)ₑ-CH₃,
und m, a, c, d und e - unabhängig voneinander - jeweils eine ganze Zahl von 0 bis 5 bedeuten,
sowie
- gegebenenfalls, bei m = 0 jedoch zwingend, ein Additiv folgender Struktur: 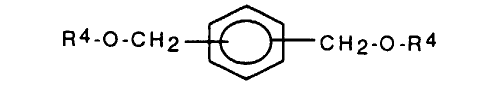 mit R⁴ = CO-(CH₂)ₙ-CH₃ oder CO-C₆H₅,
wobei n eine ganze Zahl von 0 bis 5 bedeutet.

2. Resist nach Anspruch 1, **dadurch gekennzeichnet,** daß das Basispolymer ein Copolymer aus Maleinsäureanhydrid und Glycidylmethacrylat ist.

3. Resist nach Anspruch 1, **dadurch gekennzeichnet,** daß das Basispolymer ein Copolymer aus Maleinsäureanhydrid und 4-(Acetoxymethyl) -styrol ist.

4. Resist nach Anspruch 1, **dadurch gekennzeichnet,** daß das Basispolymer ein Terpolymer aus Maleinsaureanhydrid, 4-(Acetoxymethyl)-styrol und Maleinsäure ist.

5. Resist nach Anspruch 1, **dadurch gekennzeichnet,** daß das Basispolymer ein Copolymer aus Maleinsäureanhydrid und p-Methoxystyrol ist.

6. Resist nach Anspruch 5, **dadurch gekennzeichnet**, daß er p-Bis(acetoxymethyl)-benzol als Additiv enthält.

7. Resist nach einem der Ansprüche 1 bis 6, **dadurch gekennzeichnet,** daß die photoaktive Komponente ein Oniumsalz ist.

8. Resist nach Anspruch 7, **dadurch gekennzeichnet,** daß die photoaktive Komponente Diphenyljodonium- und/oder Triphenylsulfonium-trifluormethansulfonat ist.

9. Resist nach einem oder mehreren der Ansprüche 1 bis 8, **dadurch gekennzeichnet,** daß das Lösungsmittel Methoxypropylacetat oder Diethylenglykoldimethylether ist.

10. Verwendung des Resists nach einem oder mehreren der Ansprüche 1 bis 9 in der Einlagenresisttechnik.

## Claims

1. Dry-developable positive TSI resist, characterized in that it comprises the following components:
- a suitable solvent
- a strong acid former as a photoactive component, and
- a base polymer in the form of a co- or terpolymer comprising maleic anhydride as a base unit and glycidyl methacrylate and/or a styrene derivative of the following structure as a further base unit or in the form of a terpolymer of maleic anhydride, maleic acid and a styrene derivative of the following structure: 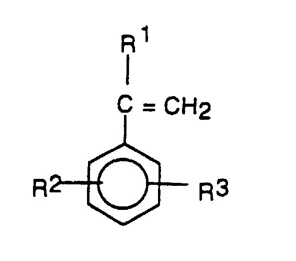 where
R¹ = H or CH₃,
R² = H or R³,
R³ = (CH₂)ₘ- OX,
X having the following meaning:
(CH₂)ₐ-CH₃, CO-(CH₂)_{c}-CH₃, or
CO-(CH₂)_{d}-O-(CH₂)ₑ-CH₃,
and m, a, c, d and e - independently of one another - each representing an integer from 0 to 5,
and
- optionally, but unconditionally for m = 0, an additive of the following structure: 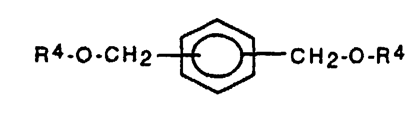 where R⁴ = CO-(CH₂)ₙ-CH₃ or CO-C₆H₅,
n representing an integer from 0 to 5.

2. Resist according to Claim 1, characterized in that the base polymer is a copolymer of maleic anhydride and glycidyl methacrylate.

3. Resist according to Claim 1, characterized in that the base polymer is a copolymer of maleic anhydride and 4-(acetoxymethyl)-styrene.

4. Resist according to Claim 1, characterized in that the base polymer is a terpolymer of maleic anhydride, 4-(acetoxymethyl)-styrene and maleic acid.

5. Resist according to Claim 1, characterized in that the base polymer is a copolymer of maleic anhydride and p-methoxystyrene.

6. Resist according to Claim 5, characterized in that it contains p-bis(acetoxymethyl)-benzene as an additive.

7. Resist according to any one of Claims 1 to 6, characterized in that the photoactive component is an onium salt.

8. Resist according to Claim 7, characterized in that the photoactive component is diphenyliodonium trifluoromethanesulphonate and/or triphenylsulphonium trifluoromethanesulphonate.

9. Resist according to one or more of Claims 1 to 8, characterized in that the solvent is methoxypropyl acetate, or diethylene glycol dimethylether.

10. Use of the resist according to one or more of Claims 1 to 9 in single-layer resist technology.

## Revendications

1. Réserve de type TSI à traitement positif développable par voie sèche, caractérisée en ce qu'elle contient les composants ci-après:
- un solvant approprié,
- un acidificateur fort à titre de composant photoactif et
- un polymère de base sous forme d'un copolymère ou d'un terpolymère comprenant de l'anhydride maléique à titre de composant principal et du méthacrylate de glycidyle et/ou un dérivé du styrène possédant la structure ci-après à titre de composant principal supplémentaire ou encore sous la forme d'un terpolymère d'anhydride maléique, d'acide maléique et d'un dérivé de styrène répondant à la structure ci-après: 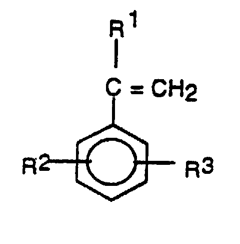 dans laquelle
R¹ représente un atome d'hydrogène ou un groupe CH₃,
R² représente un atome d'hydrogène ou R³,
R³ représente un groupe (CH₂)ₘ-OX,
dans lequel X a la signification ci-après:
(CH₂)ₐ-CH₃, CO-(CH₂)_{c}-CH₃ ou
CO-(CH₂)_{d}-O-(CH₂)ₑ-CH₃, et
m, a, c, d et e représentent - indépendamment l'un de l'autre - respectivement un nombre entier de 0 à 5,
ainsi que
- le cas échéant, mais lorsque m vaut 0, un additif répondant à la structure ci-après: 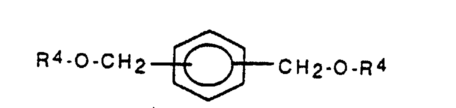 dans laquelle
R⁴ représente un groupe CO-(OH₂)ₙ-OH₃ ou un groupe CO-C₆H₅
où n représente un nombre entier de 0 à 5.

2. Réserve selon la revendication 1, caractérisée en ce que le polymère de base est un copolymère d'anhydride maléique et de méthacrylate de glycidyle.

3. Réserve selon la revendication 1, caractérisée en ce que le polymère de base est un copolymère d'anhydride maléique et du 4-(acétoxyméthyl)-styrène.

4. Réserve selon la revendication 1, caractérisée en ce que le polymère de base est un terpolymère d'anhydride maléique,du 4-(acétoxyméthyl)-styrène et d'acide maléique.

5. Réserve selon la revendication 1, caractérisée en ce que le polymère de base est un copolymère d'anhydride maléique et de p-méthoxystyrène.

6. Réserve selon la revendication 5, caractérisée en ce qu'elle contient du p-bis-(acétoxyméthyl)-benzène à titre d'additif.

7. Réserve selon l'une quelconque des revendications 1 à 6, caractérisée en ce que le composant photoactif est un sel d'onium.

8. Réserve selon la revendication 7, caractérisée en ce que le composant photoactif est le trifluorométhane-sulfonate de diphényliodonium et/ou de triphénylsulfonium.

9. Réserve selon une ou plusieurs des revendications 1 à 8, caractérisée en ce que le solvant est l'acétate de méthoxypropyle ou l'éther diméthylique de diéthylèneglycol.

10. Utilisation de la réserve selon une ou plusieurs des revendications 1 à 9 dans la technique dans laquelle on utilise des réserves à simple recouvrement.
